# EUROPÄISCHE PATENTANMELDUNG

(11) **EP 1 803 547 A1**
(43) Veröffentlichungstag der Anmeldung: **04.07.2007**
(21) Anmeldenummer: 05028696.2
(22) Anmeldetag: 30.12.2005
(51) Int. Cl.: B30B 15/06, B23K 1/00, B27N 3/20

(54) **Heizplatte für eine Plattenpresse und Verfahren zu ihrer Herstellung**

(71) Anmelder: Robert Bürkle GmbH, 72250 Freudenstadt (DE)
(72) Erfinder: Damm, Norbert, 76689 Karlsdorf-Neuthard (DE); Dölker, Gerhard, 72270 Baiersbronn (DE); Haist, Markus, 72250 Freudenstadt (DE)
(74) Vertreter: Kaiser, Magnus

(57) **Zusammenfassung**

Die Erfindung betrifft eine Heizplatte für eine Plattenpresse zum flächigen Verpressen von tafelförmigen Werkstücken mittels Druck und Wärme, bestehend aus mindestens zwei an einer im Wesentlichen parallel zur Heizplattenebene verlaufenden Trennebene 3, 11, 12, 20 fest miteinander verbundenen Teilplatten 1, 2, 10, 13, 18, 19, wobei im Inneren der Heizplatte eine Anzahl von Kanälen 5, 14, 15 vorgesehen ist, die entlang der Trennebene zwischen den Teilplatten verlaufen und mit einem jeweils nach außen führenden Vorlaufkanal 6 und einem Rücklaufkanal 7 verbunden sind. Die Teilplatten sind mittels Hochtemperatur-Vakuum-Löten mit einer in die Trennebene eingelegten Hartlot-Folie 4 miteinander verbunden.

## Beschreibung

Die Erfindung betrifft eine Heizplatte für eine Plattenpresse zum flächigen Verpressen von tafelförmigen Werkstücken mittels Druck und Wärme nach dem Oberbegriff des Anspruchs 1 sowie ein Verfahren zu deren Herstellung nach dem Oberbegriff des Anspruchs 13. Dementsprechend besteht eine Heizplatte der vorliegenden Art aus mindestens zwei, an einer im Wesentlichen parallel zur Heizplattenebene verlaufenden Trennebene fest miteinander verbundenen Teilplatten. Im Inneren der Heizplatte ist eine Anzahl von Kanälen vorgesehen, die entlang der Trennebene zwischen den Teilplatten verlaufen und mit einem jeweils nach außen führenden Vorlaufkanal sowie einem Rücklaufkanal verbunden sind. Der Begriff "Heizplatte" schließt nicht aus, dass die Heizplatte im Rahmen der vorliegenden Erfindung auch oder ausschließlich zum Kühlen eingesetzt wird.

Plattenpressen mit Heizplatten werden zur Herstellung von Spanplatten, Faserplatten oder auch Sperrholzplatten verwendet, zum Beschichten solcher Platten mit Folien oder Furnieren sowie zur Herstellung von Chipkarten, elektrischen Leiterplatten und zum Heißprägen ein- oder mehrlagiger Werkstücke. In all diesen Anwendungsfällen werden tafelförmige Werkstücke beschichtet oder die einzelnen Lagen von mehrlagigen Werkstücken untereinander verbunden, indem thermisch reagierende Kleber aktiviert werden und das Werkstück gleichzeitig in Form gepresst wird. Mitunter werden tafelförmige Werkstücke auch lediglich mit Prägungen versehen oder umgeformt bzw. laminiert, ohne die Anwesenheit von thermisch reagierenden Klebern.

In solchen Plattenpressen benötigt man Heizplatten, also beheizbare Pressplatten, die beim Verpressen des Werkstückes die erforderliche Prozesswärme in möglichst kurzer Zeit und mit ausreichend gleichmäßiger flächiger Temperatur- und Druckverteilung auf das Werkstück übertragen. Um diesen Anforderungen gerecht zu werden, sind Heizplatten der vorliegenden Art mit einer Anzahl von im Inneren der Heizplatte befindlichen Kanälen versehen, die mit einem nach außen führenden Vorlaufkanal und einem nach außen führenden Rücklaufkanal verbunden sind, so dass ein auf die erforderliche Temperatur aufgeheiztes, normalerweise flüssiges Fluid, in der Regel ein Thermoöl, durch die Kanäle gepumpt werden kann. Hierdurch wird die Heizplatte in kurzer Zeit erwärmt und auf der erforderlichen Temperatur konstant gehalten. Umgekehrt kann mittels des durch die Kanäle gepumpten Fluids die Heizplatte auch in kurzer Zeit abgekühlt werden, was für einzelne Anwendungen von Nöten ist. Gegebenenfalls wird die Heizplatte nach der vorliegenden Erfindung ausschließlich zum Kühlen eingesetzt.

Aufgrund des für den Pressvorgang in einer Plattenpresse erforderlichen hohen Pressdrucks werden Heizplatten der vorliegenden Art üblicherweise aus massivem Metall gefertigt. Um die Kanäle im Inneren der Heizplatte herzustellen, werden herkömmlicherweise im Vollmaterial Langlöcher gebohrt und anschlie-ßend durch Stopfen verschlossen. Diese Vorgehensweise ist allerdings sehr kostenintensiv, insbesondere weil die Langlochbohrungen typischerweise in der Größenordnung von 1 m Länge und mehr hergestellt werden müssen.

Um die Fertigung von Heizplatten für Plattenpressen demgegenüber kostengünstiger zu gestalten, ist aus der DE 203 01 292 U1 der Anmelderin bekannt geworden, eine Heizplatte aus zwei an einer parallel zur Heizplattenebene verlaufenden Trennebene fest miteinander verbundenen, massiven Teilplatten herzustellen, wobei die Kanalstruktur in eine der beiden Teilplatten oder alternativ auch in beide Teilplatten vor dem Zusammenfügen derselben eingefräst wird. Diese Vorgehensweise macht nicht nur die teuren Langlochbohrungen überflüssig, sondern ermöglicht darüber hinaus, Kanalstrukturen herzustellen, die nicht durch Stopfen oder dergleichen abgedichtet werden müssen. Allerdings hat sich bei solcher Art hergestellten Heizplatten herausgestellt, dass das durch die Kanäle gepumpte Thermoöl nur mit einem geringen Pumpendruck beaufschlagt werden darf, da sonst der Spaltdruck an der Trennebene, also dort, wo die beiden Teilplatten in der Kanalwand aufeinandertreffen, zu hoch wird, so dass das Thermoöl in den Spalt eindringt und sich ganzflächig zwischen den Kanälen in der Trennebene verteilt. Die Kräfte, die dann auf die Teilplatten wirken, hängen nicht nur vom Flüssigkeitsdruck, sondern auch von der Gesamtfläche der Heizplatte ab, so dass die Gefahr groß ist, dass die Teilplatten auseinandergedrückt werden und sich verziehen bzw. auswölben. Auf diese kostengünstige Art und Weise konnten daher bislang lediglich Heizplatten gefertigt werden, die nur geringe Abmessungen aufweisen oder bei denen eine langsame Durchströmung der Kanäle mit dem Thermoöl ausreicht. Ansonsten mussten weitere Sicherungen wie zwischen den Kanälen angebrachte Zuganker eingebracht werden, welche die beiden beteiligten Teilplatten aneinander formschlüssig festlegen. Dies erhöht jedoch wiederum den Fertigungsaufwand und kann hinsichtlich der Dichtheit der fertigen Heizplatte gegen Austreten des Fluids problematisch sein.

Der vorliegenden Erfindung liegt daher die Aufgabe zugrunde, eine solche bekannte, aus Teilplatten zusammengesetzte Heizplatte hinsichtlich ihrer Einsetzbarkeit und ihrer Stabilität zu verbessern.

Gelöst ist diese Aufgabe durch eine Heizplatte mit den Merkmalen des Anspruchs 1. Ein Verfahren zur Herstellung dieser Heizplatte ist im Anspruch 13 niedergelegt.

Vorteilhafte Ausgestaltungen der erfindungsgemäßen Heizplatte finden sich in den Ansprüchen 2 bis 12; bevorzugte Weiterbildungen des erfindungsgemäßen Verfahrens sind in den Ansprüchen 14 bis 16 definiert.

Die Heizplatte nach der vorliegenden Erfindung sowie das Verfahren zur Herstellung derselben unterscheiden sich von der aus der DE 203 01 292 U1 bekannten Heizplatte und deren Fertigung also im Wesentlichen dadurch, dass zwischen die Teilplatten eine Hartlot-Folie eingelegt wird und die Teilplatten dann mittels eines - für das Zusammenfügen von kleinen Bauteilen an sich bekannten - Hochtemperatur-Vakuum-Lötvorgangs untereinander verlötet werden. Die Verbindung der Teilplatten erfolgt also nicht nur randseitig umlaufend, beispielsweise durch Verschweißen, sondern auch die zwischen den Kanälen aufeinanderliegenden Bereiche der Teilplatten werden in der Trennebene mittels des Lötvorgangs fest miteinander verbunden, so dass das später durch die Kanäle fließende Fluid, insbesondere Thermoöl, nicht in einen in der Trennebene etwa vorhandenen Spalt hineinfließen kann. Die wirksame Fläche, mit der das druckbeaufschlagte Thermoöl die Teilplatten auseinanderdrücken will, entspricht dementsprechend dann nur noch der Gesamtfläche der Kanäle in Projektion auf die Plattenebene, und nicht mehr der gesamten Fläche der Heizplatte. Gleichzeitig ist die Hartlot-Folie sehr temperaturbeständig, so dass als Fluid in den Kanälen der erfindungsgemäßen Heizplatte Thermoöl verwendet werden kann, dessen Temperatur derzeit durchaus bei über 300 °C liegt. Gleichwohl ist die Fertigung der erfindungsgemäßen Heizplatte sehr kostengünstig und rationell durchführbar; denn für den Hochtemperatur-Vakuum-LötVorgang muss lediglich die aus vorgefrästen Teilplatten zusammengesetzte Heizplatte mit zwischengelegter Hartlot-Folie in einen Hochtemperatur-Vakuum-Ofen verbracht und darin behandelt werden. Hierbei hat sich überraschenderweise herausgestellt, dass das Hochtemperatur-Vakuum-Löten auch bei großflächig zusammenzufügenden Werkstücken wie den vorliegenden Teilplatten zu zufrieden stellenden Ergebnissen führt, und nicht nur bei relativ kleinen, zusammenzufügenden Bauteilen, wie es bisher an sich bekannt war.

Durch die vollflächige Verbindung zweier Teilplatten miteinander, die nur dort unterbrochen ist, wo Kanäle in der Trennebene verlaufen, kann eine Flüssigkeit, insbesondere ein üblicherweise verwendetes Thermoöl mit der für die Aufheiz- und Abkühlprozesse erforderlichen Geschwindigkeit durch die Kanäle gepumpt werden, da der zur Herstellung der Geschwindigkeit notwendige Pumpendruck sich nicht mehr auf eine Fläche verteilt, die größer ist als die Projektionsfläche der Kanäle in die Trennebene. Hierdurch ist ausgeschlossen, dass sich die aus Teilplatten zusammengesetzte Heizplatte bei zu hohen Pumpendrücken für das Thermoöl verzieht, auch ohne Zuganker verwenden zu müssen, die den Herstellungsaufwand erhöhen und gegebenenfalls eine nachteilige Öffnung des Trennebenenbereichs der Heizplatte nach außen bedingen.

Die Hartlot-Folie kann vor Auflegen derselben auf eine von zwei zusammenzufügenden Teilplatten der Kanalstruktur angepasst werden. Dies erfolgt zweckmäßigerweise so, dass die Ausfräsungen in der Teilplatte, welche die Kanäle bilden, auf die Hartlot-Folie übertragen und aus dieser ausgeschnitten werden. Es ergibt sich so eine Hartlot-Folie, welche die Trennebene mit Ausnahme der Kanalwände ganzflächig ausfüllend überdeckt.

Überraschend hat sich jedoch gezeigt, dass die Hartlot-Folie beim Hochtemperatur-Vakuum-Löten auch ganzflächig überdeckend zwischen die Teilplatten eingelegt werden kann, und zwar selbst dann, wenn die Kanäle nicht nur einseitig in einer Teilplatte eingefräst werden und die andere Teilplatte dementsprechend nur als Deckel fungiert, sondern auch dann, wenn jeweils nur ein Teilquerschnitt in jede der beiden beteiligten Teilplatten eingefräst wird. Denn beim Hochtemperatur-Vakuum-Lötvorgang fließt die Hartlot-Folie, die sich im Inneren eines Kanals befindet, an die Kanalwände und lagert sich dort bevorzugt in den Ecken des Querschnitts ab, so dass sie innerhalb des Kanals nicht mehr stört, sondern im Gegenteil durch die Ablagerung in den Kanalecken und der sich ergebenden Abrundung derselben sogar einen vorteilhaften Effekt auf einen Fluiddurchfluss durch den Kanal bietet.

Wenn für die erfindungsgemäße Heizplatte Teilplatten aus Stahl verwendet werden, was das übliche Material ist, wird als Hartlot-Folie beim Hochtemperatur-Vakuum-Löten bevorzugt eine Kupferfolie verwendet. Das Hochtemperatur-Vakuum-Löten kann dann bei ca. 1100 °C erfolgen. Dies führt bei der Herstellung der erfindungsgemäßen Heizplatte zu reproduzierbaren Ergebnissen und sehr stabilen Heizplatten.

Die erfindungsgemäße Heizplatte muss nicht aus lediglich zwei Teilplatten mit einer einzigen Trennebene zusammengesetzt sein, sondern sie kann auch aus mehreren Teilplatten bestehen, beispielsweise aus drei Teilplatten mit einer oberen und einer unteren Trennebene.

Eine bevorzugte Weiterbildung einer solchen aus drei Teilplatten zusammengesetzten Heizplatte besteht nun darin, dass nur in der unteren Trennebene Fluidkanäle eingefräst werden. In der oberen Trennebene dagegen werden lediglich Ausnehmungen für elektrische Heizelemente eingebracht, deren Querschnitt entsprechend kleiner sein kann. Elektrische Heizelemente sind derzeit jedoch noch nicht in der Lage, die beim Hochtemperatur-Vakuum-Löten auftretenden hohen Temperaturen unbeschadet zu überstehen. Dementsprechend bietet es Vorteile, wenn zunächst die unteren beiden Teilplatten, welche die untere Trennebene einschließen, mittels Hochtemperatur-Vakuum-Löten aneinandergefügt werden und die dritte Teilplatte an der oberen Trennebene nach Einlegen der elektrischen Heizelemente mittels Kleben, Schweißen oder mit Lot befestigt wird. Hier würde auch ein umlaufendes Verschweißen der oberen beiden Teilplatten ausreichen, da in der oberen Trennebene lediglich elektrische Heizelemente angeordnet sind, die naturgemäß keinen Fluiddruck auf die beiden angrenzenden Teilplatten ausüben.

Das Integrieren von elektrischen Heizelementen in eine erfindungsgemäße Heizplatte bietet den enormen Vorteil, dass auf eine externe Heizung für Thermoöl und dergleichen verzichtet werden kann. Dies macht die gesamte Plättenpresse deutlich kostengünstiger; der Energieverbrauch sinkt und die notwendige Stellfläche der Plattenpresse ist kleiner. Die gleichwohl in der unteren Trennebene vorhandenen Fluidkanäle ermöglichen das Durchleiten eines Fluids, insbesondere einer Flüssigkeit wie Thermoöl und dergleichen, um die von den elektrischen Heizelementen erzeugte Wärme möglichst homogen über die Heizplatten-Oberfläche zu verteilen sowie im Bedarfsfall die Heizplatte schnell herunterzukühlen.

Als weitere Alternative kann eine erfindungsgemäße Heizplatte auch so aufgebaut sein, dass die Heizplatte eine obere und eine untere Trennebene aufweist, wobei oberhalb der oberen Trennebene und unterhalb der unteren Trennebene je eine massive Teilplatte ohne Ausfräsungen oder sonstige Oberflächenbearbeitungen angeordnet ist. Die zwischen den Trennebenen liegende Platte ist in diesem Fall dann als Kanalplatte ausgebildet, die zur Bildung der Kanäle Ausnehmungen aufweist, die von der oberen bis zur unteren Trennebene durchgehend ausgestaltet und vorzugsweise mittels Laserstrahlung ausgeschnitten sind. Es liegt auf der Hand, dass die Fertigung einer solchen dreigeteilten Heizplatte sehr kostengünstig möglich ist, zumal das Aneinanderfügen aller drei Teilplatten in einem einzigen Arbeitsgang mittels Hochtemperatur-Vakuum-Löten erfolgt.

Sowohl der Vorlaufkanal als auch der Rücklaufkanal einer Heizplatte nach der vorliegenden Erfindung muss üblicherweise mit einem Anschlussstutzen versehen werden, um die Pumpe und gegebenenfalls das Heizmodul für das Thermofluid an die Heizplatte anschließen zu können. Besondere Vorteile bietet es nun im Rahmen der vorliegenden Erfindung, diese Anschlussstutzen ebenfalls mit einer Hartlot-Folie zu versehen, schon vor dem Hochtemperatur-Vakuum-Löten in die Heizplatte einzusetzen und im selben Arbeitsgang, in dem die Teilplatten miteinander verbunden werden, fest an die Heizplatte anzulöten. Hierdurch wird der Fertigungsprozess noch rationeller, da ein kompletter separater Arbeitsgang entfällt.

Insbesondere dann, wenn mehrere Teilplatten mit der entsprechenden Anzahl an Trennebenen und darin angeordneten Fluidkanal-Etagen nach der vorliegenden Erfindung zu einer Heizplatte zusammengefügt werden, bietet es Vorteile, wenn der Vorlaufkanal und der Rücklaufkanal, der für jede Trennebene separat vorgesehen sein kann, im Wesentlichen senkrecht zur Heizplattenebene verlaufen, wobei die Heizplatte mit jeweils einem seitlich über die wirksame Heizplattenfläche überstehenden Vorsprung zur Aufnahme des Vorlaufkanals bzw. Rücklaufkanals versehen ist. Denn hierdurch kann dann für jede Heizplattenebene ein anderer Ort für die jeweilige Vorsprünge am Umfang der Heizplatte gewählt werden, so dass die Vorlaufkanäle und die Rücklaufkanäle für die einzelnen Fluidkanal-Etagen in der Projektion auf die Heizplattenfläche nebeneinander angeordnet sind und somit leicht separat angeschlossen werden können.

Schließlich ist als weitere vorteilhafte Ausgestaltung einer erfindungsgemäßen Heizplatte hervorzuheben, dass die bisher aufgrund der Fertigung durch Langlöcher notwendige gitterartige Kanal-Geometrie mit einer Vielzahl von geradlinig verlaufenden Fluidkanälen, die beidseits in Sammelkanäle münden, von anderen Kanalformen ersetzt werden kann, beispielsweise und insbesondere von einem einzigen, mäanderförmig durch die Heizplatte verlaufenden Kanal, der einerseits in den Vorlaufkanal und andererseits in den Rücklaufkanal mündet.

Durch die erfindungsgemäß mögliche Abkehr von geradlinigen Kanälen kann jedenfalls eine strömungsgünstigere Kanalführung gewählt werden, die Druckverluste vermeidet und eine höhere Fluid-Durchflussgeschwindigkeit ermöglicht.

Ferner ist es möglich, die Heizplatten mit der vorliegenden Erfindung deutlich dünner zu fertigen, als bisher möglich. Denn zur Herstellung von LanglochBohrungen ist eine Heizplattendicke in der Größenordnung von 35 mm das Minimum, während bei Heizplatten, die nach der vorliegenden Erfindung gefertigt sind, Gesamtdicken von 15 oder 20 mm realisierbar sind. Nachdem die Heizplatten der vorliegenden Art wie eingangs erwähnt üblicherweise massiv ausgebildet sind, steigt der Energieaufwand zum Aufheizen und Abkühlen der Heizplatten mit der Plattendicke naturgemäß an. Die vorliegende Erfindung ermöglicht also auch, aufgrund der möglichen geringeren Heizplattendicke erhebliche Energieeinsparungen zu realisieren, was sich bei den Betriebskosten einer mit erfindungsgemäßen Heizplatten ausgerüsteten Plattenpresse deutlich bemerkbar macht.

Einige Ausführungsbeispiele für eine Heizplatte nach der vorliegenden Erfindung sind im Folgenden anhand der beigefügten Zeichnungen beschrieben und erläutert. Es zeigen:
- Figur 1: eine schematische seitliche Schnittdarstellung einer erfindungsgemäß hergestellten Heizplatte mit zwei Teilplatten;
- Figur 2: eine Darstellung wie Figur 1, jedoch einer Heizplatte mit zwei Teilplatten und einer zwischengelegten Kanalplatte;
- Figur 3: eine aus drei Teilplatten hergestellte Heizplatte;
- Figur 4: eine ebenfalls aus drei Teilplatten bestehende Heizplatte, jedoch mit einer Trennebene mit Fluidkanälen und einer Trennebene mit elektrischen Heizelementen;
- Figur 5: eine Heizplatte wie Figur 4, jedoch mit anders angeordneten elektrischen Heizelementen;
- Figur 6: eine Heizplatte mit elektrischen Heizelementen und insgesamt vier Teilplatten;
- Figur 7: eine Heizplatte mit vier Teilplatten, wobei zwei Trennebenen mit elektrischen Heizelementen versehen sind;
- Figur 8: eine Heizplatte mit wiederum vier Teilplatten;
- Figur 9: eine Draufsicht auf eine erste Teilplatte einer Heizplatte;
- Figur 10: eine Draufsicht auf eine zweite Teilplatte der Heizplatte, entsprechend Figur 9.

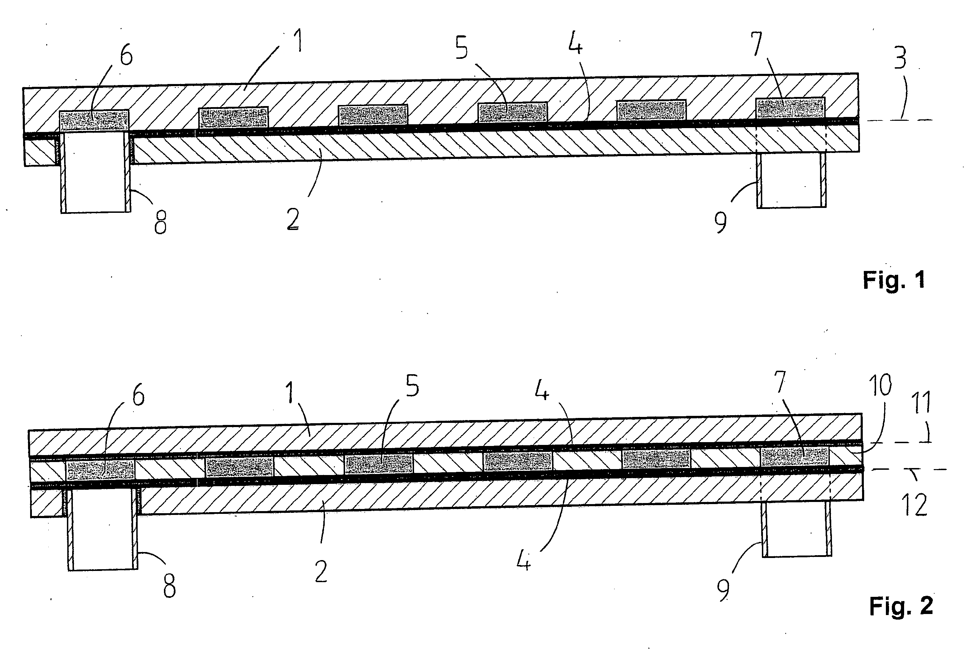

Der in Figur 1 gezeigte seitliche Schnitt einer erfindungsgemäß ausgebildeten Heizplatte zeigt schematisch eine obere Teilplatte 1 und eine untere Teilplatte 2, die an einer Trennebene 3 zusammengefügt sind. In die Trennebene 3 ist die untere Teilplatte 2 ganzflächig überdeckend eine Hartlot-Folie 4 eingebracht, welche nach einem Hochtemperatur-Vakuum-Lötvorgang die obere Teilplatte 1 und die untere Teilplatte 2 fest miteinander verbindet. In der oberen Teilplatte 1 sind Kanäle 5, hier als Fluid-Kanäle für Thermoöl ausgebildet, eingefräst, die einerseits in einen gemeinsamen Vorlaufkanal 6 und andererseits in einen gemeinsamen Rücklaufkanal 7 münden. Ein erster Anschlussstutzen 8 für den Vorlaufkanal 6 und ein zweiter Anschlussstutzen 9 für den Rücklaufkanal 7 sind mit derselben Hartlot-Folie 4 im gleichen Arbeitsgang wie beim Zusammenfügen der oberen Teilplatte 1 mit der unteren Teilplatte 2 in die untere Teilplatte 2 eingelötet worden. In dieser Darstellung wird deutlich, wie schnell und kostengünstig die Heizplatte nach dem erfindungsgemäßen Verfahren hergestellt werden kann. Lediglich in die obere Teilplatte 1 werden die Kanäle 5 mittels Fräsen eingebracht und die obere Teilplatte 1 dann auf die unbearbeitete untere Teilplatte 2 nach Auflegen der Hartlot-Folie 4 aufgelegt. Nach Einsetzen der beiden Anschlussstutzen 8, 9 wird die gesamte Heizplatte in den Hochtemperatur-Vakuum-Löt-Ofen eingebracht und verlötet. Die so fertig gestellte Heizplatte ist absolut dicht und formstabil; sie neigt auch nicht zum Verziehen und kann dementsprechend vorteilhaft dünn ausgebildet sein.

Das in Figur 2 in einer Figur 1 entsprechenden Darstellung gezeigte weitere Ausführungsbeispiel für eine erfindungsgemäße Heizplatte besteht wiederum aus einer oberen Teilplatte 1 und einer unteren Teilplatte 2, die jedoch beide plan und unbearbeitet sind. Zwischenliegend ist eine Kanalplatte 10 als dritte Teilplatte eingeschlossen, wobei aus der Kanalplatte 10 die Kanäle 5 von oben nach unten durchgehend ausgeschnitten sind. Dies kann, da die Kanäle 5 sich über die gesamte Dicke der Kanalplatte 10 erstrecken, kostengünstig mittels Laserschneiden erfolgt sein, so dass sich der relativ teure Fräsprozess zur Herstellung der Kanäle 5 erübrigt. Dementsprechend weist die hier gezeigte Heizplatte eine obere Trennebene 11 zwischen der oberen Teilplatte 1 und der Kanalplatte 10 sowie eine untere Trennebene 12 zwischen der Kanalplatte 10 und der unteren Teilplatte 2 auf, in welchen beiden Trennebenen 11, 12 zwei Hartlot-Folien 4 ganzflächig eingelegt sind.

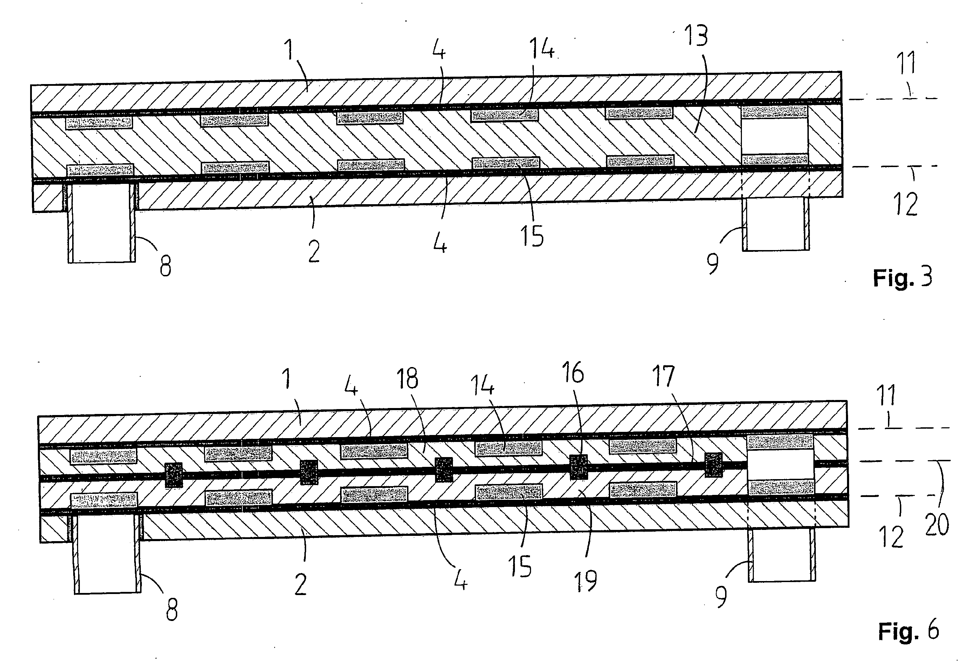

Figur 3 zeigt ein weiteres Ausführungsbeispiel einer erfindungsgemäßen Heizplatte, wiederum mit der oberen Teilplatte 1 und der unteren Teilplatte 2, die wie im Ausführungsbeispiel nach Figur 2 unbearbeitet sind sowie der oberen Trennebene 11 und der unteren Trennebene 12, da zwischen der oberen Teilplatte 1 und der unteren Teilplatte 2 eine Zwischenplatte 13 als dritte Teilplatte angeordnet ist. Diese Zwischenplatte 13 ist nun nicht mehr mit Kanälen 5 versehen, die sich über deren gesamte Dicke erstrecken, sondern an der oberen Trennebene 11 mit oberen Kanälen 14 und an der unteren Trennebene 12 mit unteren Kanälen 15. Es gibt hier also zwei separate Kanal-Etagen mit separat beaufschlagbaren Kanälen 14 bzw. 15. Die hier dargestellte Heizplatte entspricht also in etwa einer doppelten Heizplatte nach Figur 1. Die beiden Kanal-Etagen können mit jeweils separaten Vorlauf- und Rücklaufkanälen versehen sein, was hier aufgrund der schematischen Darstellung allerdings nicht sichtbar ist.

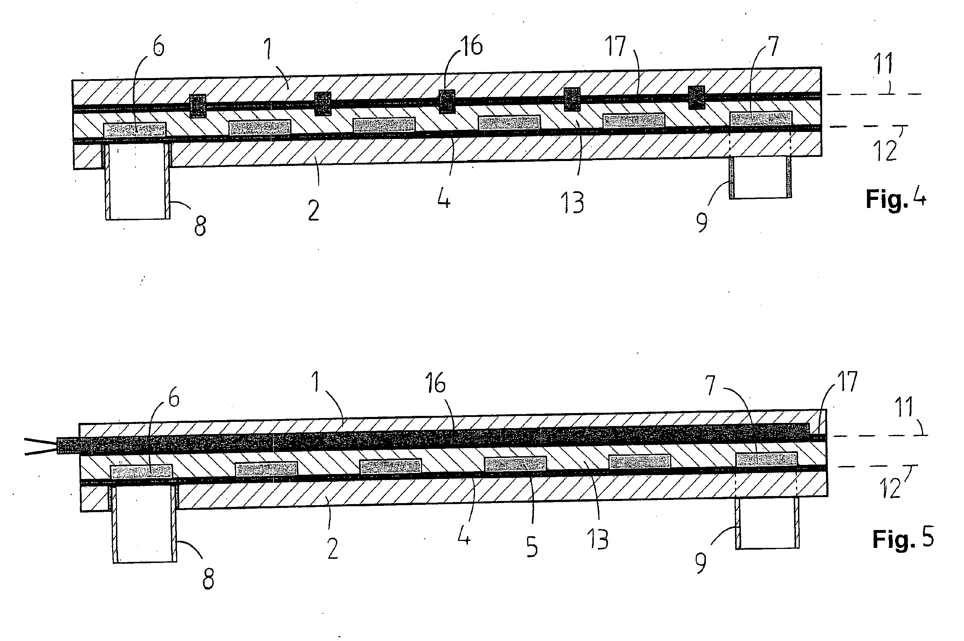

Figur 4 zeigt ein weiteres Ausführungsbeispiel einer Heizplatte nach der vorliegenden Erfindung, wobei hier wieder eine obere Trennebene 11 und eine untere Trennebene 12 vorhanden sind, da die obere Teilplatte 1 und die untere Teilplatte 2 wiederum eine Zwischenplatte 13 zwischen sich aufnehmen.

An der unteren Trennebene 12 sind Kanäle 5 als Fluidkanäle ausgebildet, während die obere Trennebene 11 mit Ausnehmungen für elektrische Heizelemente 16 versehen ist. Dementsprechend ist die untere Trennebene 11 mit einer Hartlot-Folie 4 versehen, während sich in der oberen Trennebene 11 eine Schicht Weichlot 17 zur Verbindung der oberen Teilplatte 1 mit der Zwischenplatte 13 befindet. Dies deshalb, weil die elektrischen Heizelemente 16 in aller Regel die für ein Hochtemperatur-Vakuum-Löten erforderlichen Temperaturen nicht unbeschadet überstehen. Dementsprechend ist die hier abgebildete Heizplatte in zwei Arbeitsgängen hergestellt worden: Das Aneinanderfügen der unteren Teilplatte 2 und der Zwischenplatte 13 erfolgte mittels Hochtemperatur-Vakuum-Löten mit Hartlot-Folie 4, während daran anschließend die elektrischen Heizelemente 16 eingelegt und die obere Teilplatte 1 mittels eines Lötprozesses auf die Zwischenplatte 13 aufgebracht worden ist. Anstatt des Lots könnte auch ein Harzkleber verwendet werden.

Figur 5 zeigt ein ganz ähnliches Ausführungsbeispiel wie Figur 4, wobei hier jedoch die elektrischen Heizelemente 16 senkrecht zu den Kanälen 5 verlaufend angeordnet sind, was zu einer homogeneren Temperaturverteilung an den Oberflächen der Heizplatte führt.

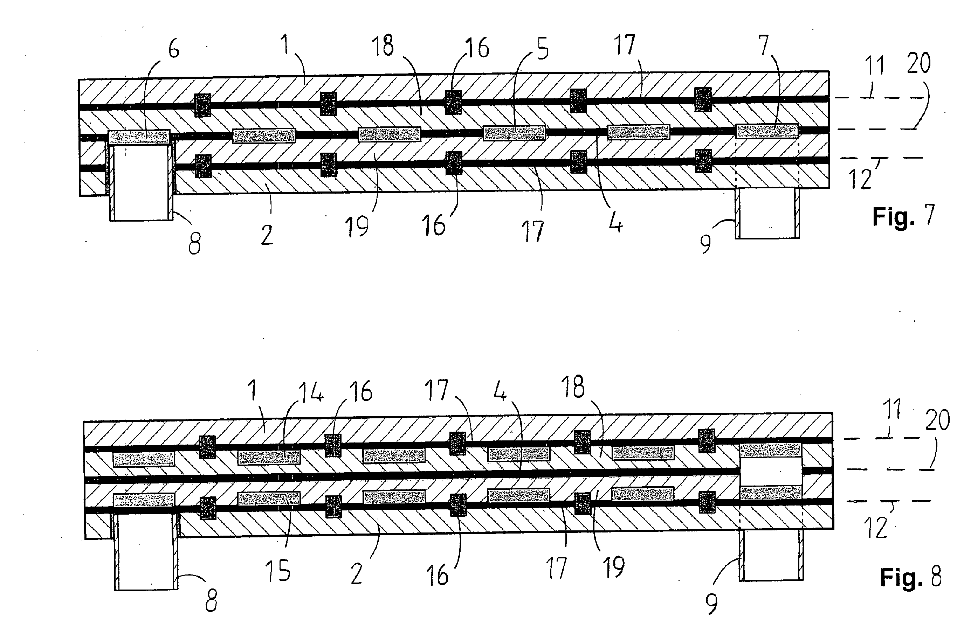

Figur 6 zeigt einen Aufbau der schematisch dargestellten Heizplatte mit oberer Teilplatte 1, unterer Teilplatte 2 und Zwischenplatte 13 wie Figur 3, wobei hier allerdings die Zwischenplatte 13 zweigeteilt ist und eine Anzahl von elektrischen Heizelementen 16 beinhaltet.

Figur 7 zeigt ein weiteres Ausführungsbeispiel mit Fluidkanälen 5 und elektrischen Heizelementen 16, wobei die hier gezeigte Heizplatte sich jedoch aus vier Teilplatten zusammensetzt, nämlich einer oberen Teilplatte 1 , einer oberen Zwischenplatte 18, einer unteren Zwischenplatte 19 und einer unteren Teilplatte 2. Dementsprechend gibt es eine obere Trennebene 11, eine untere Trennebene 12, und eine mittlere Trennebene 20. Lediglich in der mittleren Trennebene 20 sind Kanäle 5 zum Fluidtransport vorgesehen, und auch nur die obere Zwischenplatte 18 und die untere Zwischenplatte 19 sind nach dem erfindungsgemäßen Hochtemperatur-Vakuum-Lötverfahren zusammengefügt worden, während sowohl in der oberen Trennebene 11 als auch in der unteren Trennebene 12 zwei separat ansteuerbare Gruppen von elektrischen Heizelementen 16 angeordnet sind. Eine solcherart aufgebaute Heizplatte kann beispielsweise so eingesetzt werden, dass durch die Kanäle 5 lediglich Kühlwasser geführt wird, während das Aufheizen der Heizplatte von den elektrischen Heizelementen 16 übernommen wird.

Eine in Figur 8 dargestellte Weiterbildung des in Figur 7 dargestellten Aufbaus einer erfindungsgemäßen Heizplatte sieht Kanäle 5 sowohl an der oberen Trennebene 11 als auch an der unteren Trennebene 12 vor, während die mittlere Trennebene 20 weder mit Kanälen 5 noch mit Ausnehmungen für elektrische Heizelemente 16 versehen ist. Mit dem vorliegenden Aufbau ergibt sich eine noch schnellere und direktere Wechselwirkung zwischen dem durch die Kanäle 5 geleiteten Fluid und den elektrischen Heizelementen 16.

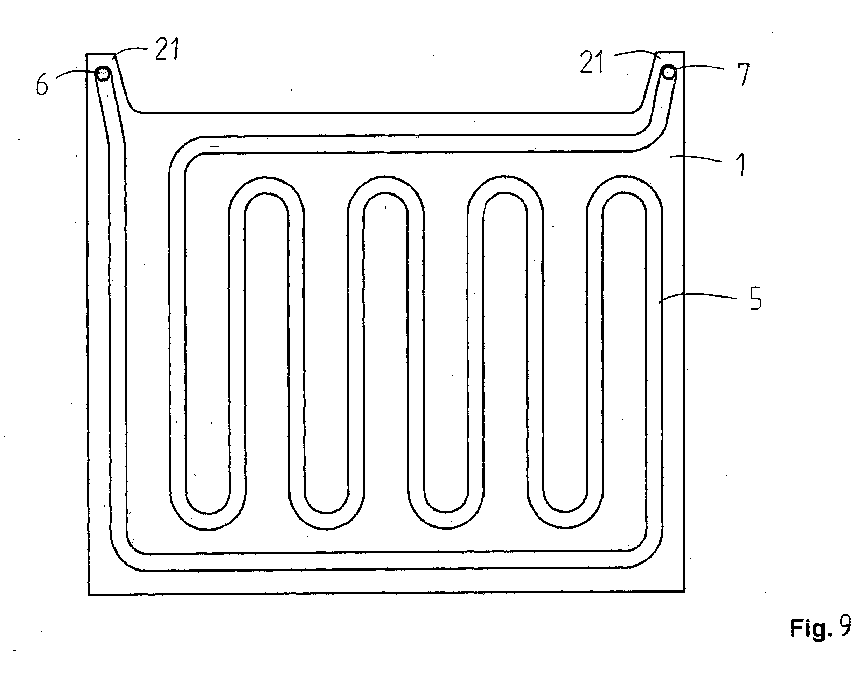

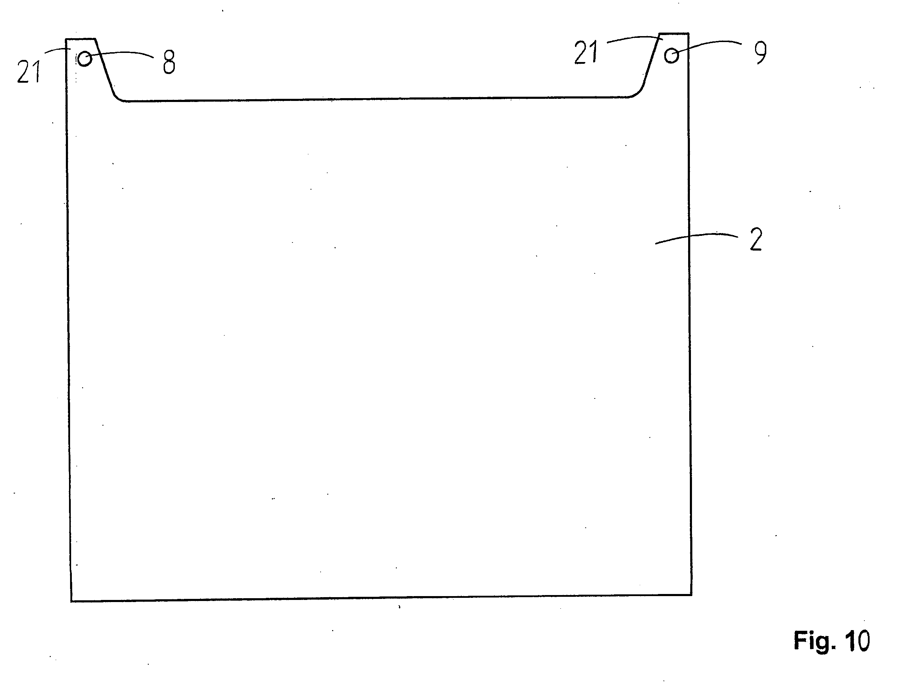

Figur 9 zeigt eine Draufsicht auf die in Figur 1 schematisch dargestellte obere Heizplatte 1, während Figur 10 eine Draufsicht auf die in Figur 1 dargestellte untere Teilplatte 2 zeigt. Während Figur 10 verdeutlicht, dass die untere Teilplatte 2 bis auf die Öffnungen für die Anschlussstutzen 8, 9 unbearbeitet geblieben ist, zeigt Figur 9, dass die Kanäle 5 letztendlich aus einem einzigen, mäanderförmig in die obere Teilplatte 1 eingefrästen Kanal 5 bestehen. In diesen wird über den senkrecht zur Plattenebene gerichteten Vorlaufkanal 6 Fluid eingeleitet, das die fertige Heizplatte über den Rücklaufkanal 7 wieder verlässt.

Wie in den Figuren 9 und 10 deutlich zu erkennen ist, sind der Vorlaufkanal 6 und der Rücklaufkanal 7 in einem jeweils seitlich über die wirksame Heizplattenfläche überstehenden Vorsprung 21 angeordnet, so dass eine weitere Teilplattenebene, die gegebenenfalls beispielsweise nach dem Vorbild des in Figur 3 dargestellten Ausführungsbeispiels ausgebildet ist, mit demgegenüber versetzt angeordneten Vorsprüngen versehen werden kann, so dass die in den unterschiedlichen Trennebenen angeordneten Vorlauf- und Rücklaufkanäle separat angeschlossen werden können.

Abschließend soll nochmals erwähnt werden, dass die erfindungsgemäßen Heizplatten nicht nur zum Übertragen von Wärme, sondern auch zur Übertragung von Kälte verwendet und dementsprechend als "Kühlplatten" in Kaltpressen eingesetzt werden können, ohne den Rahmen der Erfindung zu verlassen. Auch ein gemischter Einsatz bei Heizplatten, die zwei Trennebenen aufweisen, ist denkbar: in der ersten Trennebene wird Wärme und in der zweiten Trennebene wird Kälte in die Platte eingebracht.

## Patentansprüche

1. Heizplatte für eine Plattenpresse zum flächigen Verpressen von tafelförmigen Werkstücken mittels Druck und Wärme, bestehend aus mindestens zwei, an einer im Wesentlichen parallel zur Heizplattenebene verlaufenden Trennebene (3, 11, 12 , 20) fest miteinander verbundenen Teilplatten (1, 2, 10, 13, 18, 19), wobei im Inneren der Heizplatte eine Anzahl von Kanälen (5, 14, 15) vorgesehen ist, die entlang der Trennebene (3, 11, 12, 20) zwischen den Teilplatten (1, 2, 10, 13, 18, 19) verlaufen und mit einem jeweils nach außen führenden Vorlaufkanal (6) sowie einem Rücklaufkanal (7) verbunden sind,
**dadurch gekennzeichnet,**
**dass** die Teilplatten (1, 2, 10, 13, 18, 19) mittels Hochtemperatur-Vakuum-Löten mit einer in die Trennebene (3, 11, 12, 20) eingelegten Hartlot-Folie (4) miteinander verbunden sind.

2. Heizplatte nach Anspruch 1,
**dadurch gekennzeichnet,**
**dass** die Hartlot-Folie (4) die Trennebene (3, 11, 12, 20) mit Ausnahme der Kanalwände ganzflächig ausfüllend in der Heizplatte angeordnet ist.

3. Heizplatte nach Anspruch 1,
**dadurch gekennzeichnet,**
**dass** die Hartlot-Folie (4) beim Hochtemperatur-Vakuum-Löten ganzflächig zwischen die Teilplatten (1, 2, 10, 13, 18, 19) eingelegt worden ist.

4. Heizplatte nach mindestens einem der Ansprüche 1 bis 3,
**dadurch gekennzeichnet,**
**dass** die Hartlot-Folie (4) im Wesentlichen aus Kupfer besteht.

5. Heizplatte nach mindestens einem der Ansprüche 1 bis 4,
**dadurch gekennzeichnet,**
**dass** sie aus mindestens drei Teilplatten (1, 2, 10, 13) mit wenigstens einer oberen (11) und einer unteren Trennebene (12) zusammengesetzt ist.

6. Heizplatte nach Anspruch 5,
**dadurch gekennzeichnet,**
**dass** in der oberen Trennebene (11) Ausnehmungen für elektrische Heizelemente (16) und in der unteren Trennebene (12) Fluidkanäle (5) vorgesehen sind.

7. Heizplatte nach Anspruch 6,
**dadurch gekennzeichnet,**
**dass** die an fluidkanalfreie Trennebenen (11) angrenzenden Teilplatten (1, 13) mittels Kleben, Schweißen oder Weichlöten miteinander verbunden sind.

8. Heizplatte nach Anspruch 5,
**dadurch gekennzeichnet,**
**dass** sowohl in der oberen Trennebene (11) als auch in der unteren Trennebene (12) Fluidkanäle (5) vorgesehen sind, die vom durchgeleiteten Fluid gegenläufig durchströmbar ausgebildet sind.

9. Heizplatte nach mindestens einem der Ansprüche 1 bis 4,
**dadurch gekennzeichnet,**
**dass** die Heizplatte eine obere (11) und eine untere Trennebene (12) aufweist, wobei oberhalb der oberen Trennebene (11) und unterhalb der unteren Trennebene (12) je eine massive Teilplatte (1, 2) und zwischen den Trennebenen (11, 12) eine Kanalplatte (10) angeordnet sind, wobei die Kanalplatte (10) zur Bildung der Kanäle (5) von der oberen zur unteren Trennebene (11, 12) durchgehende Ausnehmungen aufweist.

10. Heizplatte nach mindestens einem der Ansprüche 1 bis 9,
**dadurch gekennzeichnet,**
**dass** die Kanäle (5) durch einen einzigen, mäanderförmig durch die Heizplatte verlaufenden Kanal gebildet sind, der einerseits in den Vorlaufkanal (6) und andererseits in den Rücklaufkanal (7) mündet.

11. Heizplatte nach mindestens einem der Ansprüche 1 bis 10,
**dadurch gekennzeichnet,**
**dass** der Vorlaufkanal (6) und der Rücklaufkanal (7) im Wesentlichen senkrecht zur Heizplattenebene verlaufen, wobei die Heizplatte mit jeweils einem seitlich über die wirksame Heizplattenfläche überstehenden Vorsprung (21) zur Aufnahme des Vorlaufkanals (6) bzw. Rücklaufkanals (7) versehen ist.

12. Heizplatte nach mindestens einem der Ansprüche 1 bis 11,
**dadurch gekennzeichnet,**
**dass** der Vorlaufkanal (6) und der Rücklaufkanal (7) mit je einem Anschlussstutzen (8, 9) versehen sind, welche Anschlussstutzen (8, 9) beim Verbinden der Teilplatten (1, 2, 10, 13, 18, 19) untereinander im gleichen Arbeitsgang fest mittels Hochtemperatur-Vakuum-Löten mit der Heizplatte verbunden worden sind.

13. Verfahren zur Herstellung einer Heizplatte nach Anspruch 1, mit den Verfahrensschritten:
- Bereitstellen von mindestens zwei massiven Teilplatten, die flächig aufeinandergelegt die Heizplatte bilden,
- Einarbeiten von offenen Kanälen in mindestens eine der Teilplatten und von mit diesen in Verbindung stehenden Vorlauf- und Rücklaufkanälen,
- Auflegen einer Hartlot-Folie auf eine der beiden Teilplatten,
- Aufeinanderlegen der Teilplatten derart, dass die offenen Kanäle in der Trennebene verlaufen und durch das Aufeinanderlegen der Teilplatten geschlossen werden, wobei die Hartlot-Folie in der Trennebene zu liegen kommt,
- Durchführen eines Hochtemperatur-Vakuum-Lötvorganges.

14. Verfahren nach Anspruch 13,
**dadurch gekennzeichnet, dass** die Hartlot-Folie ganzflächig zwischen die Teilplatten eingelegt wird.

15. Verfahren nach einem der Ansprüche 13 oder 14,
**dadurch gekennzeichnet,**
**dass** nach dem Hochtemperatur-Vakuum-Lötvorgang eine dritte Teilplatte auf eine zweite Trennebene aufgelegt wird, wobei in die zweite Trennebene Ausnehmungen für elektrische Heizelemente eingebracht werden, und die dritte Teilplatte mittels Kleben, Schweißen oder Löten befestigt wird.

16. Verfahren nach mindestens einem der Ansprüche 13 bis 15,
**dadurch gekennzeichnet,**
**dass** vor dem Durchführen des Hochtemperatur-Vakuum-Lötvorgangs in die Vorlauf- und Rücklaufkanäle Anschlussstutzen eingesetzt und mit Hartlot versehen werden, so dass sie beim Hochtemperatur-Vakuum-Lötvorgang festgelötet werden.

## Geänderte Patentansprüche

### Geänderte Patentansprüche gemäss Regel 86(2) EPÜ.

**1.** Heizplatte für eine Plattenpresse zum flächigen Verpressen von tafelförmigen Werkstücken mittels Druck und Wärme, bestehend aus mindestens zwei, an einer im Wesentlichen parallel zur Heizplattenebene verlaufenden Trennebene (3, 11, 12 , 20) fest miteinander verbundenen Teilplatten (1, 2, 10, 13, 18, 19), wobei im Inneren der Heizplatte eine Anzahl von Kanälen (5, 14, 15) vorgesehen ist, die entlang der Trennebene (3, 11, 12, 20) zwischen den Teilplatten (1, 2, 10, 13, 18, 19) verlaufen und mit einem jeweils nach außen führenden Vorlaufkanal (6) sowie einem Rücklaufkanal (7) verbunden sind,
**dadurch gekennzeichnet,**
**dass** die Teilplatten (1, 2, 10, 13, 18, 19) mittels Hochtemperatur-Vakuum-Löten mit einer in die Trennebene (3, 11, 12, 20) eingelegten Hartlot-Folie (4) miteinander verbunden sind, wobei die Hartlot-Folie (4) beim Hochtemperatur-Vakuum-Löten ganzflächig zwischen die Teilplatten (1, 2, 10, 13, 18, 19) eingelegt worden ist.

**2.** Heizplatte nach Anspruch 1,
**dadurch gekennzeichnet,**
**dass** die Hartlot-Folie (4) im Wesentlichen aus Kupfer besteht.

**3.** Heizplatte nach einem der Ansprüche 1 oder 2,
**dadurch gekennzeichnet,**
**dass** sie aus mindestens drei Teilplatten (1, 2, 10, 13) mit wenigstens einer oberen (11) und einer unteren Trennebene (12) zusammengesetzt ist.

**4.** Heizplatte nach Anspruch 3,
**dadurch gekennzeichnet,**
**dass** in der oberen Trennebene (11) Ausnehmungen für elektrische Heizelemente (16) und in der unteren Trennebene (12) Fluidkanäle (5) vorgesehen sind.

**5.** Heizplatte nach Anspruch 4,
**dadurch gekennzeichnet,**
**dass** die an fluidkanalfreie Trennebenen (11) angrenzenden Teilplatten (1, 13) mittels Kleben, Schweißen oder Weichlöten miteinander verbunden sind.

**6.** Heizplatte nach Anspruch 3,
**dadurch gekennzeichnet,**
**dass** sowohl in der oberen Trennebene (11) als auch in der unteren Trennebene (12) Fluidkanäle (5) vorgesehen sind, die vom durchgeleiteten Fluid gegenläufig durchströmbar ausgebildet sind.

**7.** Heizplatte nach einem der Ansprüche 1 oder 2,
**dadurch gekennzeichnet,**
**dass** die Heizplatte eine obere (11) und eine untere Trennebene (12) aufweist, wobei oberhalb der oberen Trennebene (11) und unterhalb der unteren Trennebene (12) je eine massive Teilplatte (1, 2) und zwischen den Trennebenen (11, 12) eine Kanalplatte (10) angeordnet sind, wobei die Kanalplatte (10) zur Bildung der Kanäle (5) von der oberen zur unteren Trennebene (11, 12) durchgehende Ausnehmungen aufweist.

**8.** Heizplatte nach mindestens einem der Ansprüche 1 bis 7,
**dadurch gekennzeichnet,**
**dass** die Kanäle (5) durch einen einzigen, mäanderförmig durch die Heizplatte verlaufenden Kanal gebildet sind, der einerseits in den Vorlaufkanal (6) und andererseits in den Rücklaufkanal (7) mündet.

**9.** Heizplatte nach mindestens einem der Ansprüche 1 bis 8,
**dadurch gekennzeichnet,**
**dass** der Vorlaufkanal (6) und der Rücklaufkanal (7) im Wesentlichen senkrecht zur Heizplattenebene verlaufen, wobei die Heizplatte mit jeweils einem seitlich über die wirksame Heizplattenfläche überstehenden Vorsprung (21) zur Aufnahme des Vorlaufkanals (6) bzw. Rücklaufkanals (7) versehen ist.

**10.** Heizplatte nach mindestens einem der Ansprüche 1 bis 9,
**dadurch gekennzeichnet,**
**dass** der Vorlaufkanal (6) und der Rücklaufkanal (7) mit je einem Anschlussstutzen (8, 9) versehen sind, welche Anschlussstutzen (8, 9) beim Verbinden der Teilplatten (1, 2, 10, 13, 18, 19) untereinander im gleichen Arbeitsgang fest mittels Hochtemperatur-Vakuum-Löten mit der Heizplatte verbunden worden sind.

**11.** Verfahren zur Herstellung einer Heizplatte nach Anspruch 1, mit den Verfahrensschritten:
- Bereitstellen von mindestens zwei massiven Teilplatten, die flächig aufeinandergelegt die Heizplatte bilden,
- Einarbeiten von offenen Kanälen in mindestens eine der Teilplatten und von mit diesen in Verbindung stehenden Vorlauf- und Rücklaufkanälen,
- ganzflächiges Auflegen einer Hartlot-Folie auf eine der beiden Teilplatten,
- Aufeinanderlegen der Teilplatten derart, dass die offenen Kanäle in der Trennebene verlaufen und durch das Aufeinanderlegen der Teilplatten geschlossen werden, wobei die Hartlot-Folie in der Trennebene zu liegen kommt,
- Durchführen eines Hochtemperatur-Vakuum-Lötvorganges.

**12.** Verfahren nach Anspruch 11,
**dadurch gekennzeichnet,**
**dass** nach dem Hochtemperatur-Vakuum-Lötvorgang eine dritte Teilplatte auf eine zweite Trennebene aufgelegt wird, wobei in die zweite Trennebene Ausnehmungen für elektrische Heizelemente eingebracht werden, und die dritte Teilplatte mittels Kleben, Schweißen oder Löten befestigt wird.

**13.** Verfahren nach einem der Ansprüche 11 oder 12,
**dadurch gekennzeichnet,**
**dass** vor dem Durchführen des Hochtemperatur-Vakuum-Lötvorgangs in die Vorlauf- und Rücklaufkanäle Anschlussstutzen eingesetzt und mit Hartlot versehen werden, so dass sie beim Hochtemperatur-Vakuum-Lötvorgang festgelötet werden.
